# EUROPEAN PATENT APPLICATION

(11) **EP 2 693 638 A1**
(43) Date of publication of application: **05.02.2014**
(21) Application number: 12763772.6
(22) Date of filing: 28.03.2012
(51) Int. Cl.: H03K 5/003, G01S 7/282, H03K 4/92

(54) **PULSE GENERATION DEVICE**

(30) Priority: 28.03.2011 JP 2011070480
(71) Applicant: Furukawa Electric Co., Ltd., Chiyoda-ku Tokyo 100-8322 (JP); Furukawa Automotive Systems Inc., Inukami-gun, Shiga 522-0242 (JP)
(72) Inventor: HIRAYAMA, Hiroki, Tokyo 100-8322 (JP)
(74) Representative: advotec.
(86) International application number: PCT/JP2012/058262
(87) International publication number: WO 2012/133593

(57) **Abstract**

Provided is a pulse generator that generates a pulse signal with a preferred waveform and offers increased isolation for a period of time when the pulse signal is not output.

A pulse generator 100 allows a high-frequency oscillator 101 to output a high frequency signal and allows an amplifier 102 to amplify and output the signal. The amplifier 102 amplifies the high frequency signal from the high-frequency oscillator 101 and outputs the signal only for a period of time when its drive power is supplied by a drive circuit 110. The waveform of the drive power, supplied from the drive circuit 110 to the amplifier 102, is controlled by a waveform control unit 120 such that the high frequency signal amplified by the amplifier 102 becomes an ultra-wideband pulse signal.

## Description

### Technical Field

The present invention relates to a pulse generator for generating a pulse signal, and in particular, relates to a pulse generator capable of shaping a preferred waveform for a pulse signal.

### Background Art

In UWB (ultra-wideband) radars, which measure a distance and an angle to a subject and the like with pulse signals of a very wide bandwidth in high frequency, pulse signals with a pulse width of, for example, around 1 ns are generated and used as transmission and reception signals. In order to measure a subject using a UWB radar with high precision, it is important to generate a pulse signal with a high-quality waveform. As a high-quality waveform, it is desired that a waveform be shaped into, for example, a shape as close to a rectangle as possible. In addition, in order to improve performance in measurement of a UWB radar, it is desired that output of undesired waves, such as noise signals, be minimized for a period of time when the pulse signals are not output.

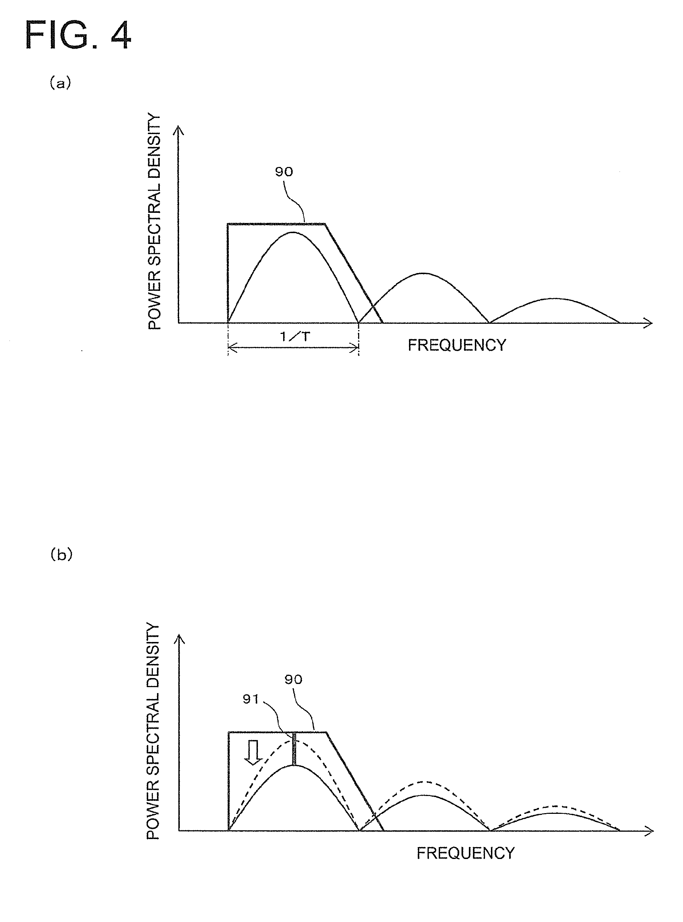

Since UWB radars use ultra-wideband pulse signals of high frequency bands, standards of UWB radio waves require an upper limit, as illustrated in Fig. 4(a) and marked with reference numeral 90, be applied to a power spectral density (dBm/MHz). It is desired that the waveform and the output strength of a pulse signal be appropriately adjusted so as not to exceed the upper limit.

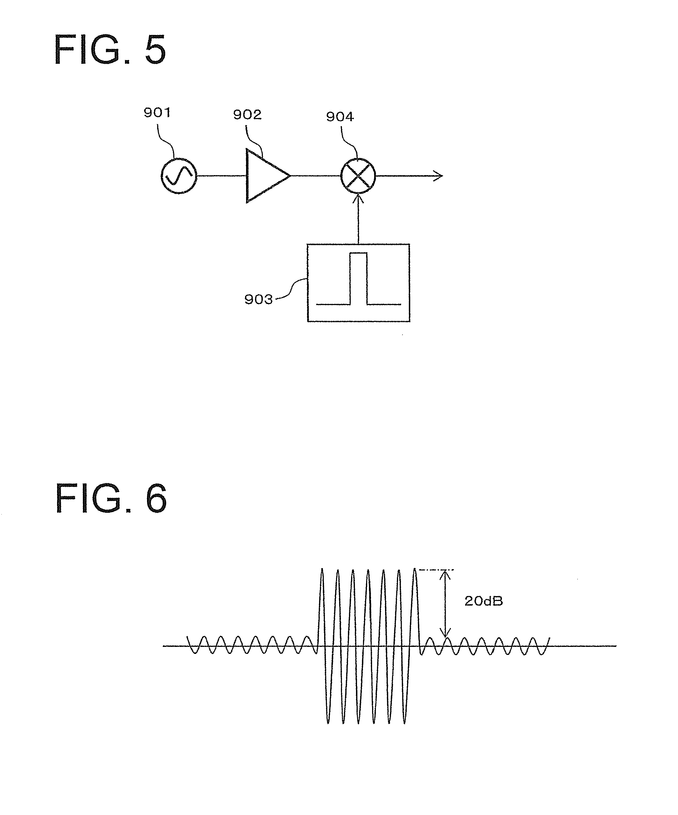

As a method for generating an ultra-wideband pulse signal, processes in which a baseband pulse signal is upconverted using a high frequency signal output from an oscillator have been conventionally known (for example, Patent Literature 1). A conventional example of an ultra-wideband pulse generator will now be described with reference to Fig. 5. A conventional pulse generator 900 includes a high-frequency oscillator 901 for generating a high frequency signal of a predetermined frequency, an amplifier 902 for amplifying the high frequency signal output from the high-frequency oscillator 901, a baseband pulse generation unit 903 for outputting a baseband pulse signal with a predetermined pulse width, and a mixer 904 for receiving and mixing the high frequency signal amplified by the amplifier 902 and the pulse signal output from the baseband pulse generation unit 903.

The mixer 904 upconverts the pulse signal received from the baseband pulse generation unit 903 using the high frequency signal received from the amplifier 902 to output the resultant signal as a high frequency pulse signal. The pulse signal output from the baseband pulse generation unit 903 is shaped into a rectangle-like shape to allow the mixer 904 to output an ultra-wideband pulse signal. The high-frequency oscillator 901, the amplifier 902, and the mixer 904 are always operative and an ultra-wideband, high frequency pulse signal is output only upon input of the pulse signal from the baseband pulse generation unit 903.

### Citation List

### Patent Literature

Patent Literature 1: JP 2009-222457 A

### Summary of Invention

### Technical Problem

A conventional pulse generator with the configuration as illustrated in Fig. 5 may be problematic in that, since the high-frequency oscillator, the amplifier, the mixer, and the like need to be operated even when no pulse signal is input into the mixer from the baseband pulse generation unit, a signal from the high-frequency oscillator may leak from the mixer as a noise signal. The mixer has an isolation capability of around 20 dB at most for a leakage signal, as schematically illustrated in Fig. 6. Hence, as illustrated in an example in Fig. 4(b), a radar with this type of pulse generator involves a leakage signal at a relatively high level (illustrated in Fig. 4(b), marked with reference numeral 91) superimposed on a received signal. This may lead to a need for a reduction in power of a transmitting signal as illustrated in Fig. 4(b) in order to stay within the limit applied to the power spectral density (dBm/MHz). This may result in a problem of a reduction in detectable distance.

The present invention has been achieved in light of the challenge described above, and it is an object of the present invention to provide a pulse generator that generates a pulse signal with a preferred waveform and offers an increased isolation for a period of time when a pulse signal is not output.

### Solution to Problem

As a solution to the challenge described above, a first aspect of the pulse generator according to the present invention is a pulse generator that allows a high-frequency oscillator to output a high frequency signal and allows an amplifier to amplify the high frequency signal and output a high frequency pulse signal, the pulse generator including a drive circuit and a waveform control unit, the drive circuit including: a resistor connected at one end to a voltage source; a capacitor connected at one end to an input end and connected at the other end to the other end of the resistor; a NOT logic transistor connected at one end to the other end of the resistor; and a current amplifier connected at one end to the transistor and connected at the other end to an output end, the drive circuit being configured to supply drive power to the amplifier connected to the output end, the waveform control unit being configured to output a control signal to the input end such that the drive power has a waveform shaped into a predetermined shape and is output from the drive circuit, the transistor being configured to receive the control signal through the capacitor and to control the current amplifier such that the current amplifier turns ON when the control signal is lower than a predetermined threshold and stays OFF otherwise.

Another aspect of the pulse generator according to the present invention is that the threshold is set between a voltage bias set from the voltage source through the resistor and a minimum value of the control signal input from the capacitor, and the threshold is set lower than a minimum value of an undesired voltage oscillation associated with the control signal.

Still another aspect of the pulse generator according to the present invention is that the waveform control unit includes: timing control means for controlling a rising/falling timing of the drive power with high precision; waveform shaping means for controlling a rising speed/a falling speed of the drive power such that the waveform is shaped into a pulse-like shape; amplitude control means for controlling a height of the drive power; and strength control means for controlling with current a strength of the drive power.

Yet another aspect of the pulse generator according to the present invention is that the waveform control unit is formed with a SerDes (Serializer/Deserializer) of a PLD (programmable logic device).

Another aspect of the pulse generator according to the present invention is that the waveform control unit is formed with a SerDes of an FPGA (field programmable gate array).

Another aspect of the pulse generator according to the present invention is that the waveform control unit uses multi-step pre-emphasis of an emphasis function of the FPGA as the waveform shaping means.

Another aspect of the pulse generator according to the present invention is that the waveform control unit selects a maximum value of the multi-step pre-emphasis as the waveform shaping means, and selects a maximum value of the multi-step current strength as the strength control means.

### Advantageous Effects of Invention

The present invention can provide a pulse generator that generates a pulse signal with a preferred waveform and offers an increased isolation for a period of time when a pulse signal is not output.

### Brief Description of Drawings

Fig. 1 is a block diagram of the configuration of a pulse generator according to a first embodiment of the present invention.
Fig. 2 is a temporal waveform chart illustrating an example of an ultra-wideband high frequency pulse signal generated by the pulse generator according to the first embodiment.
Fig. 3 is a temporal waveform chart illustrating an example of waveforms of signals output from the drive circuit and the waveform control unit of the pulse generator according to the first embodiment.
Fig. 4 (a) is a schematic diagram of the limit applied to the power spectral density of the UWB pulse signal.
Fig. 4 (b) is a schematic diagram of the limit applied to the power spectral density of the UWB pulse signal.
Fig. 5 is a block diagram illustrating an example of a conventional ultra-wideband pulse signal generator.
Fig. 6 is a temporal waveform chart of a signal output from the mixer of the conventional ultra-wideband pulse signal generator.
Fig. 7(a) is a schematic temporal waveform chart of a waveform of a control signal received from the waveform control unit via a capacitor.
Fig. 7(b) is a schematic temporal waveform chart of the waveform of the control signal received from the waveform control unit via the capacitor.

### Description of Embodiments

A preferred embodiment of the pulse generator according to the present invention will now be described in detail with reference to the drawings. Like reference numerals will be used for components with like functions to simplify the illustration and the description.

### (First embodiment)

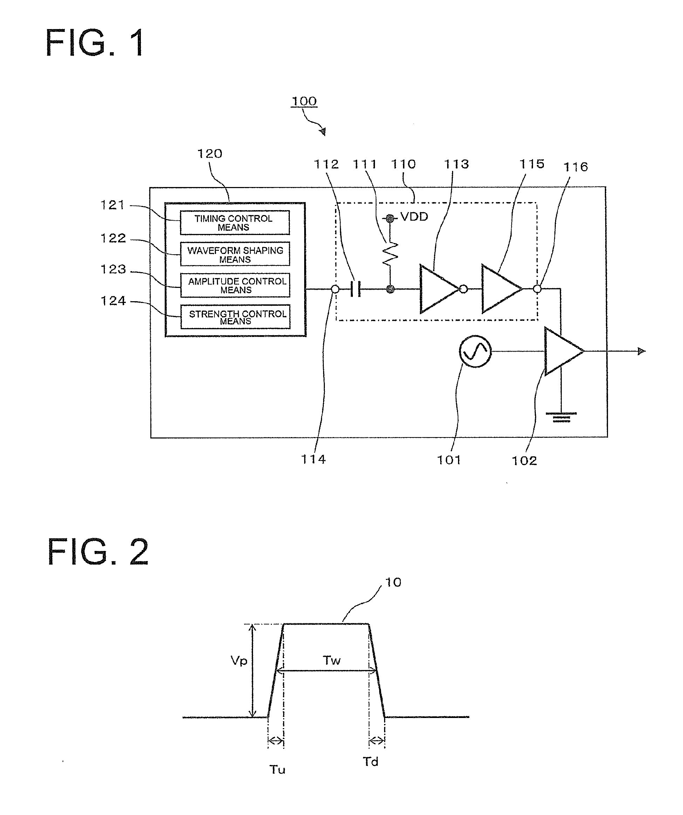

With reference to Fig. 1, the pulse generator according to the first embodiment of the present invention will now be described. Fig. 1 is a block diagram illustrating a configuration of a pulse generator 100 according to the present embodiment. In the pulse generator 100 in Fig. 1, a high-frequency oscillator 101 outputs a high frequency signal, and an amplifier 102 amplifies and outputs the signal. The amplifier 102 amplifies and outputs the high frequency signal from the high-frequency oscillator 101 only when its drive power is supplied from a drive circuit 110. The pulse generator 100 according to the present embodiment uses a waveform control unit 120 to control the waveform of the drive power supplied from the drive circuit 110 to the amplifier 102 such that the high frequency signal amplified by the amplifier 102 becomes an ultra-wideband pulse signal. Note that the amplifier 102 is not limited by a one-step type, but it may be of an arrangement with two or more steps connected in series.

The drive circuit 110 includes a resistor (pull-up resistor) 111 connected at one end to a power source with a voltage VDD, a capacitor 112 connected at one end to an input end 114 and connected at the other end to the other end of the resistor 111, a NOT logic transistor 113 connected at one end to the other end of the resistor 111 in parallel with the capacitor 112, and a current amplifier 115 connected at one end to the transistor 113 and connected at the other end to an output end 116. The input end 114 is connected to the waveform control unit 120 to receive a predetermined control signal, and the output end 116 is connected to the amplifier 102 to supply its drive power. The current amplifier 115 amplifies a current output from the transistor 113 to supply the power for driving the amplifier 102.

The waveform control unit 120, as means for shaping the waveform of the drive power output from the drive circuit 110, includes timing control means 121 for controlling the timing of rising/falling of the drive power with high precision, waveform shaping means 122 for controlling the rising speed/falling speed of the drive power to shape the waveform into a pulse-like shape, amplitude control means 123 for controlling the height of the drive voltage, and strength control means 124 for controlling, with current, the strength of the drive power.

A drive voltage of around 2 to 3 V and a drive current of around 60 mA are needed to drive the amplifier 102. In addition, in order to cause the amplifier 102 to output the high frequency ultra-wideband pulse signal, it is necessary to control the waveform of the drive voltage in a high frequency band by, for example, allowing the drive voltage, needed to drive the amplifier 102, to rise and fall rapidly at a predetermined timing. For the waveform shaping of the drive voltage in a high frequency band, a SerDes (Serializer/Deserializer) of an FPGA (Field Programmable Gate Array), for example, may be used.

A signal output by the SerDes of the FPGA, however, has an amplitude of around 350 mV, which is lower than that of the voltage needed to drive the amplifier 102. In addition, the output signal of the SerDes involves an overshoot and an undershoot and has a problem of ringing caused after the signal output. This makes it difficult to use the FPGA to directly control the amplifier 102 to turn ON/OFF. Thus, the pulse generator 100 according to the present embodiment includes the drive circuit 110 for supplying to the amplifier 102 the drive power (the drive voltage and the drive current) with a preferred waveform. The pulse generator 100 is, in addition, configured to use the waveform control unit 120 for controlling the drive power output by the drive circuit 110. The SerDes of the FPGA described above may be employed for the waveform control unit 120.

The pulse generator 100 according to the present embodiment is configured to generate and output an ultra-wideband high frequency pulse signal, as illustrated in Fig. 2, for example. In Fig. 2, a pulse height of pulse signal 10 is denoted as Vp, a pulse width as Tw, and a rising time and a falling time as Tu and Td, respectively. The waveform of the ultra-wideband high frequency pulse signal is shaped such that, for example, the pulse height Vp = 2 to 3 V, the pulse width Tw = 1ns ± 150 ps, and the rising time Tu = falling time Td ≤ 200 ps. Here, the pulse width Tw is a time width with the pulse height Vp at 1/2. The waveform control unit 120 controls the drive power output from the drive circuit 110 such that the pulse signal 10 as described above is output from the amplifier 102.

In the waveform control unit 120, the timing control means 121 is used to allow the output of the drive power to start/stop at a predetermined timing. The waveform shaping means 122 is used to enable control over the rising speed/falling speed of the drive power, such that the rising time Tu/falling time Td of the high frequency pulse signal 10 is equal to or less than, for example, 200 ps. The pulse height Vp of the high frequency pulse signal 10 can be controlled with the amplitude control means 123. Furthermore, the strength of the high frequency pulse signal 10 can be controlled with the strength control means 124. The strength control means 124 can control a current to the drive circuit 110 to control the strength of the drive power output from the drive circuit 110.

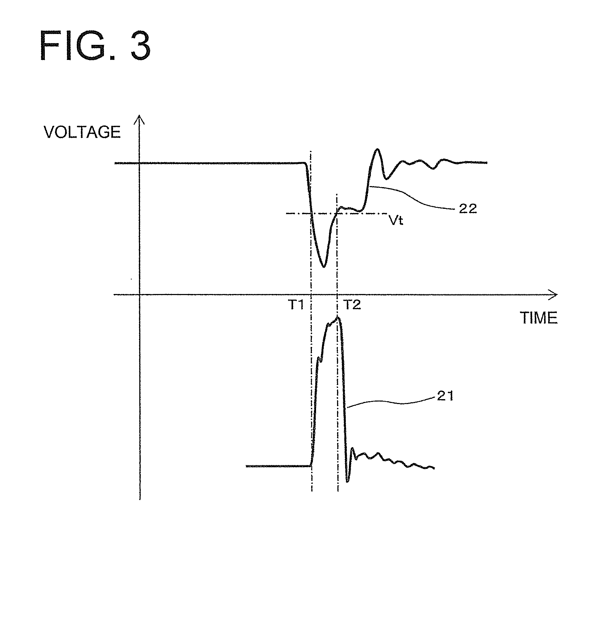

Fig. 3 is a diagram of an exemplary control signal output from the waveform control unit 120 to the drive circuit 110 and an exemplary drive voltage output from drive circuit 110 to the amplifier 102 in accordance with the control signal. In this diagram, reference numeral 21 denotes the drive voltage output to the amplifier 102, and reference numeral 22 denotes the voltage of the control signal output to the drive circuit 110. The waveform control unit 120 outputs to the drive circuit 110 the control signal with a voltage at around 120 to 300 mV and a current at around 24 mA. In the case where the FPGA is used as the waveform control unit 120, the strength control means 124 can use a maximum setting value to set the current to 24 mA. The use of the maximum setting value by the strength control means 124 may cause a problem of an increase of the ringing. In the present embodiment, the transistor 113 is used to allow a reduction of the ringing. In addition, the drive circuit 110 outputs to the amplifier 102 the drive power with a voltage at around 2 to 3 V and a current at around 60 mA.

With reference to Fig. 3, when the control signal 22 output by the waveform control unit 120 quickly decreases to reach a threshold Vt at a time T1, the drive voltage 21 rises to start supplying the power to the amplifier 102. Subsequently, when the control signal 22 increases again to reach the threshold Vt at a time T2, the drive voltage 21 quickly falls to interrupt the power supply to the amplifier 102. This allows the drive circuit 110 to supply to the amplifier 102 between the times T1 and T2 the drive voltage 21 that is a pulse wave shaped into a substantially rectangle-like shape.

The pulse generator 100 according to the present embodiment is configured to allow the drive circuit 110 to supply the drive voltage 21, as illustrated in Fig. 3, to the amplifier 102 in accordance with the control signal 22 output by the waveform control unit 120. The drive circuit 110 is configured to use the NOT logic transistor 113 to allow the current amplifier 115, which supplies the drive voltage 21 to the amplifier 102, to turn ON/OFF its drive power.

The transistor 113 operates as a comparator that compares an input signal to a predetermined threshold (referred to as Vt) to output a signal of "H" (high) or "L" (low). If the output signal of the transistor 113 is "H," the drive power is supplied to the current amplifier 115. The transistor 113 is connected to the resistor 111, which is connected at one end to the power source with the voltage VDD, and this applies a predetermined voltage bias (referred to as a DC bias VDC) to the transistor. The DC bias VDC is set to a voltage at around 600 mV, which is needed to drive the transistor 113. To use the transistor 113 as the NOT logic type, the input signal is input to the inverted input side, so that an input signal with a voltage lower than the threshold Vt causes the transistor 113 to output the "H" signal. Thus, the threshold Vt is set lower than the DC bias VDC so that the transistor 113 normally outputs the "L" signal.

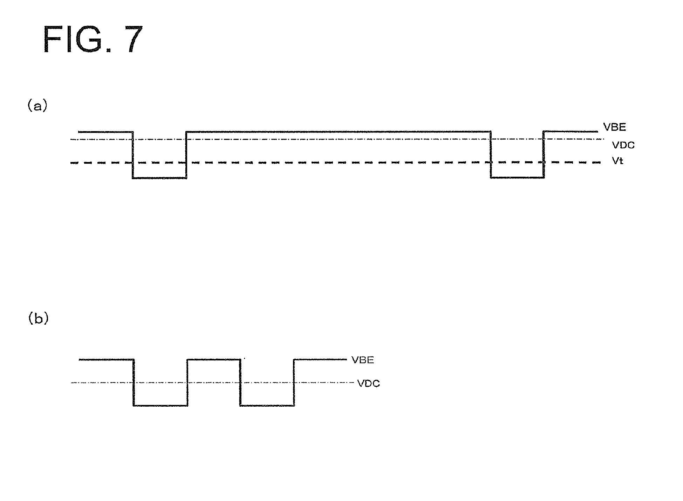

When the control signal 22 is input, as illustrated in Fig. 3, from the waveform control unit 120 to the drive circuit 110, an alternating-current component of the control signal 22 is input through the capacitor 112 to be added to the DC bias VDC. Fig. 7 (a) is a schematic diagram of the resultant signal (referred to as VBE). Signals with a constant pulse length (with a duty ratio of 1:1), as illustrated in Fig. 7(b), are subjected to the waveform shaping by the waveform control unit 120 to obtain the signals illustrated in Fig. 7(a). The waveform control unit 120 performs the waveform shaping such that an amplitude of a pulse over the DC bias VDC is minimized, and the areas of the signals oscillating above and below the DC bias VDC as a reference are similar. As a result, the waveform control unit 120 outputs signals, as an example illustrated in Fig. 7(a), with the voltage exceeding the DC bias VDC significantly reduced and a duration thereof increased to have a significantly higher duty ratio. The duty ratio is preferably equal to or higher than, for example, 1:100. The number one in the duty ratio corresponds to a pulse signal of downwardly convex.

In the case where signals with a significantly higher duty ratio, as an example illustrated in Fig. 7(a), are input into the transistor 113, a large amplitude of the pulse signal of downwardly convex below the DC bias VDC facilitates setting the threshold Vt of the transistor 113 between the DC bias VDC and the voltage of the pulse signal of downwardly convex. This allows the transistor 113 to output the "H" signal when the pulse signal of downwardly convex is lower than the threshold Vt, and to output the "L" signal when the pulse signal is again higher than the threshold Vt.

By increasing the duty ratio at the waveform control unit 120 to increase the amplitude of the pulse signal of downwardly convex, a large difference is created in magnitude of the amplitude with an undesired oscillation, such as the ringing. Because of this, the drive circuit 110 according to the present embodiment can facilitate setting the threshold Vt of the transistor 113 between the two.

By setting the threshold Vt of the transistor 113 such that an undesired oscillation by the ringing or the like does not cause the transistor 113 to output the "H" signal, an influence of the ringing and the like on the control signal from the waveform control unit 120 can be precluded. As a result, the drive voltage 21 supplied to the amplifier 102 is shaped into a pulse-like shape between the times T1 and T2, as in an example illustrated in Fig. 3, and the influence of the ringing and the like can be sufficiently reduced.

In the case where the FPGA is used as the waveform control unit 120, an emphasis function of the FPGA may be used to output the rapidly rising control signal 22 to the drive circuit 110. The FPGA allows setting of 16 steps of pre-emphasis as the waveform shaping means 122, and eight steps of current strength as the strength control means 124. Setting a maximum value each for the waveform shaping means 122 and the strength control means 124 allows the drive circuit 110 to output the control signal 22 as illustrated in Fig. 3. In place of the FPGA, a SerDes of a PLD (Programmable Logic Device) may be used to form the waveform control unit 120.

As described above, the drive power with a voltage at around 2 to 3 V and a current at around 60 mA needs to be supplied by the drive circuit 110 in order to drive the amplifier 102. Meanwhile, the DC bias VDC applied by the power source with the voltage VDD through the resistor 111 to the transistor 113 is around 600 mV. Hence, the current amplifier 115 amplifies the current of the signal "H" output by the transistor 113 to around 60 mA and also amplifies the voltage to 2 to 3 V. Alternatively, the voltage may be amplified by the transistor 113.

In the pulse generator 100 according to the present embodiment, by increasing the duty ratio of the control signals significantly at the waveform control unit 120 and inputting the signals to the transistor 113, ON/OFF control of the drive power, which is to be supplied to the amplifier 102, can be ensured. As a result, the isolation of the amplifier 102 for a period of time when the high frequency pulse signal is not output is increased significantly.

As described above, the pulse generator 100 according to the present embodiment is configured to allow the waveform control unit 120 to control the drive circuit 110, which enables the amplifier 102 to output the preferred wide-band high frequency pulse signal 10. In other words, the drive circuit 110 can achieve a desired pulse height and a desired pulse strength as the drive power, which is to be supplied to the amplifier 102, through the control by the waveform control unit 120. The pulse generator 100 according to the present embodiment can generate the high frequency pulse signal with a preferred waveform and achieve increased isolation for a period of time when the pulse signal is not output.

Note that the description in the present embodiment refers to one example of a pulse generator according to the present invention, and the present invention is not limited by this example. Detailed arrangements and specific operations of the pulse generator according to the present embodiment can be modified as appropriate without departing from the spirit of the present invention.

### Reference Signs List

- 100: Pulse generator
- 101: High-frequency oscillator
- 102: Amplifier
- 110: Drive circuit
- 111: Resistor
- 112: Capacitor
- 113: Transistor
- 114: Input end
- 115: Current amplifier
- 116: Output end
- 120: Waveform control unit
- 121: Timing control means
- 122: Waveform shaping means
- 123: Amplitude control means
- 124: Strength control means

## Claims

1. A pulse generator that allows a high-frequency oscillator to output a high frequency signal and allows an amplifier to amplify the high frequency signal and output a high frequency pulse signal,
the pulse generator comprising a drive circuit and a waveform control unit,
the drive circuit comprising:
a resistor connected at one end to a voltage source;
a capacitor connected at one end to an input end and connected at the other end to the other end of the resistor;
a NOT logic transistor connected at one end to the other end of the resistor; and
a current amplifier connected at one end to the transistor and connected at the other end to an output end,
the drive circuit being configured to supply drive power to the amplifier connected to the output end,
the waveform control unit being configured to output a control signal to the input end such that the drive power has a waveform shaped into a predetermined shape and is output from the drive circuit,
the transistor being configured to receive the control signal through the capacitor and to control the current amplifier such that the current amplifier turns ON when the control signal is lower than a predetermined threshold and stays OFF otherwise.

2. The pulse generator according to claim 1, wherein
the threshold is set between a voltage bias set from the voltage source through the resistor and a minimum value of the control signal input from the capacitor, and the threshold is set lower than a minimum value of an undesired voltage oscillation associated with the control signal.

3. The pulse generator according to claim 1 or 2, wherein
the waveform control unit comprises:
timing control means for controlling a rising/falling timing of the drive power with high precision;
waveform shaping means for controlling a rising speed/a falling speed of the drive power such that the waveform is shaped into a pulse-like shape;
amplitude control means for controlling a height of the drive power; and
strength control means for controlling with current a strength of the drive power.

4. The pulse generator according to claim 3, wherein
the waveform control unit is formed with a SerDes (Serializer/Deserializer) of a PLD (programmable logic device).

5. The pulse generator according to claim 3, wherein
the waveform control unit is formed with a SerDes of an FPGA (field programmable gate array).

6. The pulse generator according to claim 5, wherein
the waveform control unit uses multi-step pre-emphasis of an emphasis function of the FPGA as the waveform shaping means.

7. The pulse generator according to claim 6, wherein
the waveform control unit selects a maximum value of the multi-step pre-emphasis as the waveform shaping means, and selects a maximum value of the multi-step current strength as the strength control means.
